(19) Europäisches Patentamt

European Patent Office

Office européen des brevets

(11) Veröffentlichungsnummer: **0 367 981 B1**

(12) **EUROPÄISCHE PATENTSCHRIFT**

(45) Veröffentlichungstag der Patentschrift: **12.05.93**

(21) Anmeldenummer: **89118284.2**

(22) Anmeldetag: **03.10.89**

(51) Int. Cl.⁵: **G01R 19/175**, H03K 5/153

(54) **Spannungs–Nullpunktdetektor.**

(30) Priorität: **27.10.88 DE 3836532**

(43) Veröffentlichungstag der Anmeldung:
**16.05.90 Patentblatt 90/20**

(45) Bekanntmachung des Hinweises auf die
Patenterteilung:
**12.05.93 Patentblatt 93/19**

(84) Benannte Vertragsstaaten:
**DE FR GB IT**

(56) Entgegenhaltungen:
**FR–A– 2 598 812**
**US–A– 4 311 956**

**ELEKTOR, Band 9, Nrs. 7/8, Juli/August 1983,
Seiten 7–83; O.M. KELLOGG:
"Zero–crossing detector**

**MULLARD TECHNICAL COMMUNICATIONS,
Nr. 132, Oktober 1976, Seiten 63–68; D.R.
ARNSTRONG: "Zero–crossing detector circuits"**

**E.D.N. ELECTRICAL DESIGN NEWS, Band 28,
Nr. 9, April 1983, Seite 221; R. POINT et al.:
"Comparator provides zero–voltage switching"**

**NEUES AUS DER TECHNIK, Band 2, Mai 1985,
Seite 4: "Operationsverstärker"**

(73) Patentinhaber: **TEMIC TELEFUNKEN microelectronic GmbH
Theresienstrasse 2
W–7100 Heilbronn(DE)**

(72) Erfinder: **Nutz, Karl–Diether
Blumenstrasse 33
W–7101 Oedheim(DE)**

(74) Vertreter: **Maute, Hans–Jürgen, Dipl.–Ing.
TEMIC TELEFUNKEN microelectronic GmbH
Postfach 3535 Theresienstrasse 2
W–7100 Heilbronn (DE)**

## Beschreibung

Bei Phasenanschnittsteuerungen wird eine Rampenspannung mit der Netzspannung synchronisiert. Dabei muß der Rampenstart unabhängig von Parameterschwankungen immer exakt zu ein und derselben Zeit einsetzen.

Aus der FR-A-2 598 812 ist ein Spannungs-Nullpunktdetektor bekannt, bei dem die Synchronisationsspannung in einen Synchronisationsstrom umgewandelt wird, der durch zwei Transistoren gleichgerichtet wird. Aus dieser Druckschrift sind keine Angaben zur weiteren Beschaltung des Nullpunktdetektors bekannt.

In US-P-4 311 956 wird ein Nullpunktdetektor beschrieben, bei dem ein gleichgerichteter Strom an einem Spannungsteiler in eine Spannung gewandelt und einem Komparator zum Vergleich mit einer Referenzspannung zugeführt wird.

Diese bekannten Nullpunktdetektoren weisen jedoch den Nachteil auf, daß es aufgrund von Bauelementtoleranzen oder Temperaturänderungen zu Verschiebungen im Ausgangssignal des Detektors kommt.

Der Erfindung liegt die Aufgabe zugrunde, einen Spannungs-Nullpunktdetektor anzugeben, der ein Nullpunktsignal exakt im Bereich des Nullpunktes der Netz- bzw. Synchronisierspannung auslöst, und zwar unabhängig von anderen Parametern wie Temperatur oder Bauelementetoleranzen. Diese Aufgabe wird nach der Erfindung durch einen Spannungs-Nullpunktdetektor mit den kennzeichnenden Merkmalen des Anspruchs 1 gelöst.

Beim Spannungs-Nullpunktdetektor nach der Erfindung wird nicht ein über einen Synchronisierwiderstand eingekoppelter Strom ausgewertet und mit einem intern erzeugten Toleranz- und Tk-behafteten Strom verglichen, sondern es wird eine Synchronisierspannung mit einer intern erzeugten, temperaturstabilen Referenzspannung verglichen.

Die Erfindung wird im folgenden an Ausführungsbeispielen erläutert.

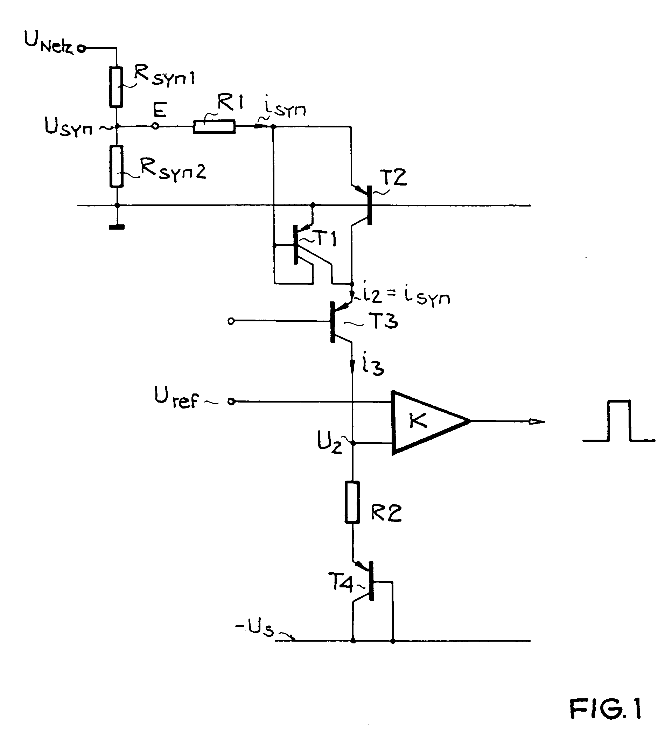

Bei der in der Figur 1 dargestellten Schaltung wird die Netzspannung $U_{NETZ}$ durch einen Widerstandteiler mit den Widerständen $R_{SYN1}$ und $R_{SYN2}$ heruntergeteilt, und zwar auf eine Spannung $U_{SYN}$, mit der das in der Figur dargestellte Nullpunktdetektor-IC betrieben werden kann. Die heruntergeteilte Spannung $U_{SYN}$ hat im Ausführungsbeispiel einen Wechselspannungswert von 8 V. An das mit dem Bezugspunkt verbundene Ende des Widerstandes $R_{syn2}$ ist der Emitter eines Transistors T1 und an das andere Ende des Widerstandes $R_{syn2}$ ist über einen Widerstand R1 der Emitter des Transistors T2 angeschlossen. Die Basis des Transistors T1, die mit dem Kollektor des Transistors T1 kurzgeschlossen ist, ist mit dem Emitter des Transistors T2 verbunden. Dieser Schaltungsteil bewirkt, daß über den Widerstand R1 in der positiven Halbwelle der Netzspannung ein Strom i1 = (U1 − $U_{BET2}$)/R1 und in der negativen Halbwelle ein Strom i1 = (U1 − $U_{BET1}$)/R1 fließt. Dieser Strom i1 fließt, nur reduziert um den jeweiligen sehr kleinen Basisstrom des Transistors T1 bzw. T2 und gleichgerichtet als Gleichstrom i2 in den Emitter des Transistors T3. Der Transistor T3 hat die Aufgabe, die Kollektorpotentiale der Transistoren T1 und T2 konstant zu halten. Auf diese Weise wird die Kollektorspannungsrückwirkung eliminiert.

Der Strom i3 fließt durch den Widerstand R2 und erzeugt an ihm eine Spannung $U_{R2}$. Die Spannung $U_{R2}$ ergibt zusammen mit der Spannung $U_{BE}$ des als Diode geschalteten Transistors T4 die Spannung U2, die mittels des Komparators K mit einer Referenzspannung $U_{ref}$ verglichen wird. Der Komparator K liefert das Nullpunkt-Detektorsignal. Der Kollektor und die Basis des Transistors T4 sind mit dem Potential $−U_s$ verbunden. Das Potential $−U_s$ beträgt beispielsweise −10V.

Der als Diode geschaltete Transistor T4 hat die Aufgabe, mit seiner $U_{BE}$-Spannung die $U_{BE}$-Spannungen der Transistoren T1 bzw. T2 zu kompensieren. Wegen $U_{BET4}$ + $U_{R2}$ = U2 gilt $U_{R2}$ = $U_{R1}$ und wegen $U_{BET1, T2}$ = $U_{BET4}$ gilt $U_{syn}$ = U2. Dies gilt unter der Voraussetzung, daß R1 = R2 ist. Damit die Widerstände R1 und R2 gleichen Temperaturgang haben und auch in anderen Bauelementparametern übereinstimmen, müssen die Widerstände R1 und R2 Teile der gleichen integrierten Schaltung sein und das gleiche Grundmaterial haben.

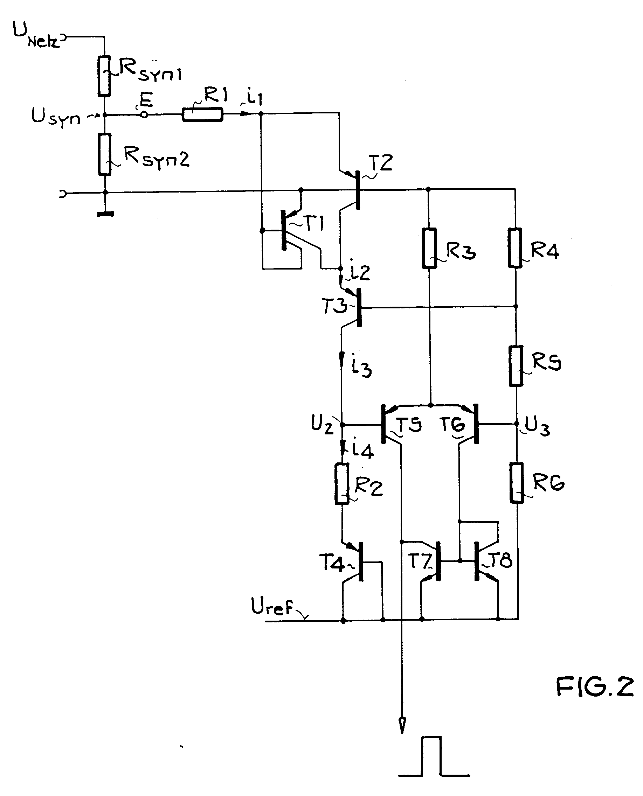

Die Schaltung der Figur 2 zeigt ein spezielles Ausführungsbeispiel der Schaltung der Figur 1. Bei der Schaltung der Figur 2 wird auch wieder die Netzspannung $U_{Netz}$ durch den Spannungsteiler mit den Widerständen $R_{syn1}$ und $R_{syn2}$ auf die Spannung $U_{syn}$ heruntergeteilt, und zwar auf einen Spannungswert, mit dem das in der Figur 2 dargestellte Nullpunktdetektor-IC betrieben werden kann. An das mit dem Bezugspunkt verbundene Ende des Widerstandes $R_{syn2}$ ist der Emitter eines Transistors T1 und an das andere Ende des Widerstandes $R_{syn2}$ ist über einen Widerstand R1 der Emitter des Transistors T2 angeschlossen. Die Basis des Transistors T1, die mit dem Kollektor des Transistors T1 kurzgeschlossen ist, ist mit dem Emitter des Transistors T2 verbunden. Dieser Schaltungsteil bewirkt wie bei der Schaltung der Figur 1, daß über den Widerstand R1 in der positiven Halbwelle der Netzspannung ein Strom i1 = (U1 − $U_{BET2}$)/R1 und in der negativen Halbwelle ein Strom i1 = (U1 − $U_{BET1}$)/R1 fließt. Dieser Strom i1 fließt nun, wie in Verbindung mit der Figur 1 beschrieben, reduziert um den jeweiligen Basisstrom des Transistors T1 bzw. T2 als gleichgerichteter Strom i2 in den Emitter des Transistors T3. Der Transistor T3 hat wieder die Aufgabe, die Kollektorpotentiale der Transistoren T1 und T2 konstant zu halten.

Der Kollektorstrom i3 des Transistors T3 fließt in eine Reihenschaltung, die aus dem mit dem Kollektor des Transistors T3 verbundenen Widerstand R2 und dem als Diode geschalteten Transistor T4 besteht. Außer dem Strom i3 fließt in den Widerstand R2 noch der Basisstrom des Transistors T5, so daß der in den Widerstand R2 fließende Gesamtstrom als Strom i4 bezeichnet wird.

Vernachlässigt man wegen der hohen Verstärkungswerte (B-Werte) der Transistoren, die immer > 50 sind, die Basisströme, so hat der Strom i1 praktisch die gleiche Größe wie der Strom i4. Dies bedeutet, daß der Absolutwert derjenigen Spannung (U2), die als Bezugspunkt die Spannung $U_{ref}$ hat und zwischen dem mit dem Kollektor des Transistors T3 und der Basis des Transistors T5 verbundenen Knotenpunkt A und dem Bezugspunkt $U_{ref}$ liegt, praktisch gleich dem Absolutwert der Spannung U1 ist, und zwar unter der Voraussetzung, daß der Widerstandswert des Widerstandes R1 gleich dem Widerstandswert des Widerstandes R2 ist. Die Spannung U2 hat also den gleichen Absolutwert wie die Spannung U1, doch haben beide Spannungen unterschiedliche Bezugspunkte. Diese Bedingung ist die Voraussetzung dafür, daß zum einen nur eine Betriebsspannung benötigt wird und zum anderen der Wert von U1 unabhängig von Parameterstreuungen als U2 in der Schaltung abgebildet wird.

Die Schaltung der Figur 2 weist weiterhin einen Spannungsteiler auf, der aus den Widerständen R4, R5 und R6 besteht. Das eine Ende des Widerstandes R4 ist mit der Basis des Transistors T2 verbunden, während das andere Ende des Widerstandes R4 sowohl mit der Basis des Transistors T3 als auch mit dem Widerstand R5 verbunden ist. Das eine Ende des Widerstandes R6 des Spannungsteilers ist mit der Referenzspannung $U_{ref}$ als Bezugspunkt verbunden. Die am Widerstand R6 gewonnene Spannung U3 ($U_{ref}$) bildet die Schaltschwelle für den aus den Transistoren T5 und T6 bestehenden Komparator, dem außer der Spannung U3 die Spannung U2 zugeführt wird. Die Spannung U2 wird an die Basis des Transistors T5 und die Spannung U3 wird an die Basis des Transistors T6 gelegt. Erreicht die Spannung U2 von oben her kommend den Wert der temperaturstabilen Spannung U3, so wird der Nullpunktimpuls ausgelöst.

Der aus den Transistoren T7 und T8 bestehende Stromspiegel verbessert das Schaltverhalten der Synchronisierschaltung. Die Emitter der beiden Stromspiegeltransistoren T7 und T8 sind mit $U_{ref}$ als Bezugspunkt verbunden. Der Kollektor des Transistors T7 ist mit dem Kollektor des Transistors T5 verbunden und die Basen der Transistoren T7 und T8 sind mit dem Kollektor des Transistors T8 sowie mit dem Kollektor des Transistors T6 verbunden.

Da sowohl absolut wie auch auf den Temperaturgang bezogen R1 = R2 und $U_{BET2}$ = $U_{BET4}$ sind, sind bei der Schaltung nach der Erfindung alle Parameterschwankungen unwirksam und der Synchronisationsimpuls ist nur noch von der Synchronisierspannung abhängig.

**Patentansprüche**

1. Integrierter Spannungs-Nullpunktdetektor mit einem ersten Widerstand ($R_{SYN1}$), an dem aus der Netzspannung ($U_{NETZ}$) eine Synchronisationsspannung ($U_{SYN}$) erzeugt wird, einem zweiten Widerstand ($R_1$), über den ein zur Synchronisationsspannung ($U_{SYN}$) proportionaler Synchronisationsstrom ($i_1$) fließt, einem ersten Transistor ($T_2$), der mit dem zweiten Widerstand ($R_1$) verbunden ist und die positive Halbwelle des Synchronisationsstroms ($i_1$) in die eine Richtung fließen läßt, einem zweiten Transistor ($T_1$), der ebenfalls mit dem zweiten Widerstand ($R_1$) verbunden ist und die negative Halbwelle des Synchronisationsstroms ($i_1$) in die gleiche Richtung fließen läßt, und einem Komparator (K), an dessen einen Eingang eine Referenzspannung ($U_{REF}$) anliegt, und dessen Ausgang das Nullpunkt-Detektorsignal liefert, dadurch gekennzeichnet, daß eine Reihenschaltung aus einem dritten Widerstand ($R_2$) mit dem gleichen Widerstandswert wie der zweite Widerstand ($R_1$) und einem als Diode geschalteten weiteren Transistor ($T_4$) vorgesehen ist, die vom gleichgerichteten Synchronisationsstrom durchflossen wird, und daß dem anderen Eingang des Komparators (K) die an der Reihenschaltung ($R_2$, $T_4$) abfallende, temperaturgangkompensierte Spannung ($U_2$) zum Vergleich mit der Referenzspannung ($U_{REF}$) zugeführt wird.

2. Spannungs-Nullpunktdetektor nach Anspruch 1, dadurch gekennzeichnet, daß ein Spannungsteiler ($R_{SYN1}$, $R_{SYN2}$) vorgesehen ist, der die Netzspannung ($U_{NETZ}$) auf die Synchronisationsspannung ($U_{SYN}$) herunterteilt.

3. Spannungs-Nullpunktdetektor nach einem der Ansprüche 1 oder 2, dadurch gekennzeichnet, daß ein vierter Transistor ($T_3$) vorgesehen ist, der die Kollektorpotentiale des ersten und des zweiten Transistors ($T_2$, $T_1$) konstant hält.

**4.** Spannungs – Nullpunktdetektor nach Anspruch 3, dadurch gekennzeichnet, daß der Emitter des vierten Transistors ($T_3$) mit den Kollektoren des ersten und zweiten Transistors ($T_2$, $T_1$) verbunden ist.

**5.** Spannungs – Nullpunktdetektor nach einem der Ansprüche 1 bis 4, dadurch gekennzeichnet, daß der Kollektor und die Basis des Transistors der Reihenschaltung ($T_4$) auf einem Bezugspunkt mit dem Potential einer Referenzspannung liegt.

**6.** Spannungs – Nullpunktdetektor nach einem der Ansprüche 1 bis 5, dadurch gekennzeichnet, daß der Komparator (K) aus zwei Transistoren ($T_5$, $T_6$) besteht.

**7.** Spannungs – Nullpunktdetektor nach einem der Ansprüche 1 bis 6, dadurch gekennzeichnet, daß die Emitter der beiden Transistoren ($T_5$, $T_6$) des Komparators miteinander und mit der Basis des ersten Transistors ($T_2$) über einen Widerstand ($R_3$) verbunden sind.

**8.** Spannungs – Nullpunktdetektor nach einem der Ansprüche 1 bis 7, dadurch gekennzeichnet, daß eine Stromspiegelschaltung ($T_7$, $T_8$) zur Verbesserung des Schaltverhaltens der Schaltung vorgesehen ist, die zwei Transistoren ($T_7$, $T_8$) aufweist, daß der Kollektor des einen Stromspiegeltransistors ($T_7$) mit dem Kollektor des einen Transistors ($T_5$) des Komparators verbunden ist und daß der Kollektor des anderen Stromspiegeltransistors ($T_8$) mit dem Kollektor des anderen Transistors ($T_6$) des Komparators verbunden ist.

## Claims

**1.** Integrated zero voltage detector with a first resistor ($R_{syn1}$), at which a synchronizing voltage ($U_{syn}$) is produced from the mains voltage ($U_{Netz}$), a second resistor ($R_1$), via which a synchronizing current ($i_1$), which is proportional to the synchronizing voltage ($U_{syn}$), flows, a first transistor ($T_2$), which is connected to the second resistor ($R_1$) and lets the positive half-cycle of the synchronizing current ($i_1$) flow in one direction, a second transistor ($T_1$), which is also connected to the second resistor ($R_1$) and lets the negative half-cycle of the synchronizing current ($i_1$) flow in the same direction, and a comparator (K), to one input of which a reference voltage ($U_{ref}$) is applied and the output of which delivers the zero detector signal, characterised in that a series connection consisting of a third resistor ($R_2$), which has

the same resistance value as the second resistor ($R_1$), and another transistor ($T_4$), which is connected as a diode, is provided, through which connection the rectified synchronizing current flows, and that the temperature variation – compensated voltage ($U_2$), which is dropped across the series connection ($R_2$, $T_4$), is supplied to the other input of the comparator (K) for comparison with the reference voltage ($U_{ref}$).

**2.** Zero voltage detector according to claim 1, characterised in that a voltage divider ($R_{syn1}$, $R_{syn2}$) is provided which divides the mains voltage ($U_{Netz}$) into the synchronizing voltage ($U_{syn}$).

**3.** Zero voltage detector according to claim 1 or 2, characterised in that a fourth transistor ($T_3$) is provided which maintains the collector potentials of the first and second transistors ($T_2$, $T_1$) constant.

**4.** Zero voltage detector according to claim 3, characterised in that the emitter of the fourth transistor ($T_3$) is connected to the collectors of the first and second transistors ($T_2$, $T_1$).

**5.** Zero voltage detector according to any one of claims 1 to 4, characterised in that the collector and the base of the transistor of the series connection ($T_4$) lie on a reference point having a reference voltage potential.

**6.** Zero voltage detector according to any one of claims 1 to 5, characterised in that the comparator (K) consists of two transistors ($T_5$, $T_6$).

**7.** Zero voltage detector according to any one of claims 1 to 6, characterised in that the emitters of the two transistors ($T_5$, $T_6$) of the comparator are connected together and to the base of the first transistor ($T_2$) via a resistor ($R_3$).

**8.** Zero voltage detector according to any one of claims 1 to 7, characterised in that a current mirror connection ($T_7$, $T_8$), which comprises two transistors ($T_7$, $T_8$), is provided to improve the switching behaviour of the circuit, that the collector of one current mirror transistor ($T_7$) is connected to the collector of one transistor ($T_5$) of the comparator, and that the collector of the other current mirror transistor ($T_8$) is connected to the collector of the other transistor ($T_6$) of the comparator.

## Revendications

1. Détecteur de tension nulle intégré, comportant : une première résistance ($R_{SYN1}$) sur laquelle on produit, à partir de la tension du réseau ($U_{NETZ}$), une tension de synchronisation ($U_{SYN}$); une deuxième résistance ($R_1$) par laquelle s'écoule un courant de synchronisation ($i_1$) proportionnel à la tension de synchronisation ($U_{SYN}$); un premier transistor ($T_2$) qui est relié à la deuxième résistance ($R_1$) et qui laisse passer dans une première direction l'alternance positive du courant de synchronisation ($i_1$); un deuxième transistor ($T_1$) qui est également relié à la deuxième résistance ($R_1$) et laisse passer dans la même direction l'alternance négative du courant de synchronisation ($i_1$); et un comparateur (K) à une première entrée duquel est appliquée une tension de référence ($U_{REF}$) et dont la sortie fournit le signal de détecteur de zéro, caractérisé par le fait qu'il est prévu un groupement série constitué par une troisième résistance ($R_2$) ayant la même valeur que la deuxième résistance ($R_1$) et par un autre transistor ($T_4$) monté en diode, ce groupement série étant parcouru par le courant de synchronisation redressé, et par le fait que la tension ($U_2$), compensée des variations de température, découlant de la chute de tension dans le groupement ($R_2,T_4$), est appliquée à l'autre entrée du comparateur (K) aux fins de comparaison avec la tension de référence ($U_{REF}$).

2. Détecteur de tension nulle selon revendication 1, caractérisé par le fait qu'il est prévu un diviseur de tension ($R_{SYN1}$, $R_{SYN2}$) qui divise la tension du réseau ($U_{NETZ}$) en la ramenant à la tension de synchronisation ($U_{SYN}$).

3. Détecteur de tension nulle selon l'une des revendications 1 ou 2, caractérisé par le fait qu'il est prévu un quatrième transistor ($T_3$) qui maintient constant les potentiels de collecteur du premier et du deuxième transistor ($T_2$, $T_1$).

4. Détecteur de tension nulle selon revendication 3, caractérisé par le fait que l'émetteur du quatrième transistor ($T_3$) est relié aux collecteurs du premier et du deuxième transistor ($T_2$, T1).

5. Détecteur de tension nulle selon l'une des revendications 1 à 4, caractérisé par le fait que le collecteur et la base du transistor du groupement série ($T_4$) sont à un point de référence ayant le potentiel d'une tension de référence.

6. Détecteur de tension nulle selon l'une des revendications 1 à 5, caractérisé par le fait que le comparateur (K) est constitué par deux transistors ($T_5$, $T_6$).

7. Détecteur de tension nulle selon l'une des revendications 1 à 6, caractérisé par le fait que les émetteurs des deux transistors ($T_5$, $T_6$) du comparateur sont reliés l'un à l'autre et, par l'intermédiaire d'une résistance ($R_3$), à la base du premier transistor ($T_2$).

8. Détecteur de tension nulle selon l'une des revendications 1 à 7, caractérisé par le fait que, pour améliorer le comportement de commutation du circuit, il est prévu un circuit miroir de courant ($T_7$, $T_8$) présentant deux transistors ($T_7$, $T_8$), par le fait que le collecteur du premier transistor du miroir de courant ($T_7$) est relié au collecteur du premier transistor ($T_5$) du comparateur, et par le fait que le collecteur de l'autre transistor du miroir de courant ($T_8$) est relié au collecteur de l'autre transistor ($T_6$) du comparateur.

EP 0 367 981 B1

FIG.1

6

FIG.2